# EUROPEAN PATENT APPLICATION

(11) **EP 4 672 322 A1**
(43) Date of publication of application: **31.12.2025**
(21) Application number: 24759975.6
(22) Date of filing: 18.01.2024
(51) Int. Cl.: H01L 23/36, H01L 23/12, H05K 1/02, H05K 7/20

(54) **SEMICONDUCTOR DEVICE AND MOUNTING METHOD**

(30) Priority: 20.02.2023 JP 2023024019
(71) Applicant: FUJITSU LIMITED, Kawasaki-shi, Kanagawa 211-8588 (JP)
(72) Inventor: IKEDA, Junya, Kawasaki-shi, Kanagawa 211-8588 (JP); NAKATA, Yoshihiro, Kawasaki-shi, Kanagawa 211-8588 (JP); SASAKI, Shinya, Kawasaki-shi, Kanagawa 211-8588 (JP); MORITA, Masaru, Kawasaki-shi, Kanagawa 211-8588 (JP)
(74) Representative: Haseltine Lake Kempner LLP
(86) International application number: PCT/JP2024/001224
(87) International publication number: WO 2024/176668

(57) **Abstract**

Heat generated by a semiconductor chip is efficiently dissipated.

A metal plate 12 is embedded in a printed circuit board 11. A semiconductor package 13 includes a semiconductor chip 13a and is provided with connection terminals 13g1 to 13g4, which electrically connect the semiconductor chip 13a and the printed circuit board 11, on a surface 13i that faces a surface 11a of the printed circuit board 11. Out of a gap between the surface 11a and the surface 13i, a first region that covers the connection terminals 13g1 to 13g4 is filled with a first filling material 14, and in the gap, at least a part of a second region where the semiconductor chip 13a and the metal plate 12 overlap in plan view is filled with a second filling material 15 with higher thermal conductivity than the first filling material 14.

## Description

### Technical Field

The present disclosure relates to a semiconductor device and a mounting method.

### Background Art

In some semiconductor devices, a semiconductor package including a semiconductor chip is mounted on a printed circuit board via connection terminals such as a ball grid array (BGA). To ensure the strength and reliability of bonding, the gap between the semiconductor package and the printed circuit board may be filled with a resin-based material called an "underfill material".

A semiconductor device in which a semiconductor chip and a heat dissipating substrate are connected by bumps, and a central part of an active region, that is, a part where heat generation is concentrated, is covered with an encapsulating material with higher thermal conductivity than the encapsulating material that covers an outer periphery has been proposed. In another proposed semiconductor device, the gap between a semiconductor chip and a wiring board connected by a BGA is filled with a resin in which a large amount of filler made of a material with a higher thermal conductivity than the bumps. In yet another proposed semiconductor device, a high-frequency chip and a first substrate are flip-chip bonded, the first substrate and a second substrate are electrically connected using solder balls so that the second substrate faces the chip, and heat is dissipated by thermal vias provided in the second substrate. A heat dissipation device including a coin built into a printed circuit board, a via that is thermally coupled to a heat source and directly connected to one surface of the coin, and a via that is thermally connected to a heat sink and directly connected to the other surface of the coin has also been proposed.

### Citation List

### Patent Literature

PTL 1: International Publication Pamphlet No. WO 2020/012604
PTL 2: Japanese Laid-open Patent Publication No. 11-67831
PTL 3: Japanese Laid-open Patent Publication No. 2009-158742
PTL 4: U.S. Patent No. 9,661,738

### Summary of Invention

### Technical Problem

In recent years, semiconductor packages including high-power semiconductor chips, such as an antenna in package (AiP), have appeared. In a conventional semiconductor device where this type of semiconductor package is mounted on a printed circuit board, heat generated by the semiconductor chip is not dissipated with sufficient efficiency.

In one aspect, an object of the present disclosure is to provide a semiconductor device and a mounting method capable of efficiently dissipating heat from a semiconductor chip.

### Solution to Problem

According to one aspect, there is provided a semiconductor device including: a printed circuit board; a metal plate embedded in the printed circuit board; a semiconductor package; a first filling material; and a second filling material. The semiconductor package includes a semiconductor chip and is provided with first connection terminals for electrically connecting the semiconductor chip and the printed circuit board on a second surface that faces a first surface of the printed circuit board. The first filling material fills a first region, which covers the first connection terminals, out of a gap between the first surface and the second surface. The second filling material has higher thermal conductivity than the first filling material and fills at least a part of a second region, where the semiconductor chip and the metal plate overlap in a plan view, of the gap.

According to another aspect, a mounting method is provided.

### Advantageous Effects of Invention

According to one aspect, the present disclosure efficiently dissipates heat from a semiconductor chip.

### Brief Description of Drawings

FIG. 1 is a cross-sectional view of an example of a semiconductor device according to a first embodiment.
FIG. 2 is a top view of an example of the semiconductor device according to the first embodiment.
FIG. 3 is a cross-sectional view of a semiconductor device that is a comparative example.
FIG. 4 depicts a mounted example of a heat sink.
FIG. 5 depicts a modification of the semiconductor device according to the first embodiment.
FIG. 6 is a top view of one example of a semiconductor device according to a second embodiment.
FIG. 7 is a top view of one example of a semiconductor device according to a third embodiment.
FIG. 8 depicts a first step in a mounting method.
FIG. 9 depicts a second step in the mounting method.
FIG. 10 depicts a process in another mounting method.

### Description of Embodiments

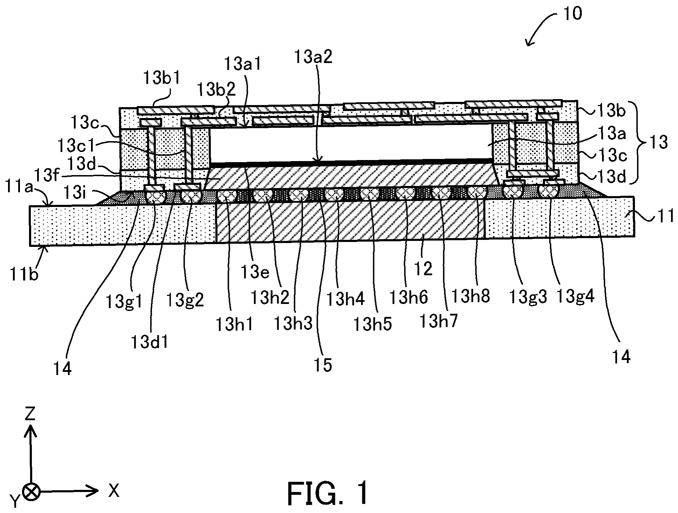

Preferred embodiments of the present disclosure will be described below with reference to the accompanying drawings. In the following description, the expression "upper surface" refers to an X-Y plane that faces upward (the +Z direction) for a semiconductor device 10 in FIG. 1 and the like. In the same way, the expression "up" refers to an upward direction (or +Z direction) for the semiconductor device 1 in FIGS. 1 and the like. The expression "lower surface" refers to an X-Y plane that faces downward (the -Z direction) for the semiconductor device 10 in FIG. 1 and the like. In the same way, "down" refers to a downward direction (the -Z direction) for the semiconductor device 10 in FIG. 1 and the like. The same directions are referred to as needed in other drawings. The expression "plan view" refers when viewing an X-Y plane. The expressions "front surface", "up", "lower surface", "down", and "side surface" are merely convenient expressions for specifying relative positional relationships and do not limit the technical scope of the present embodiments. For example, the expressions "up" and "down" do not necessarily refer to the vertical direction with respect to the ground. That is, the "up" and "down" directions are not limited to the direction of gravity.

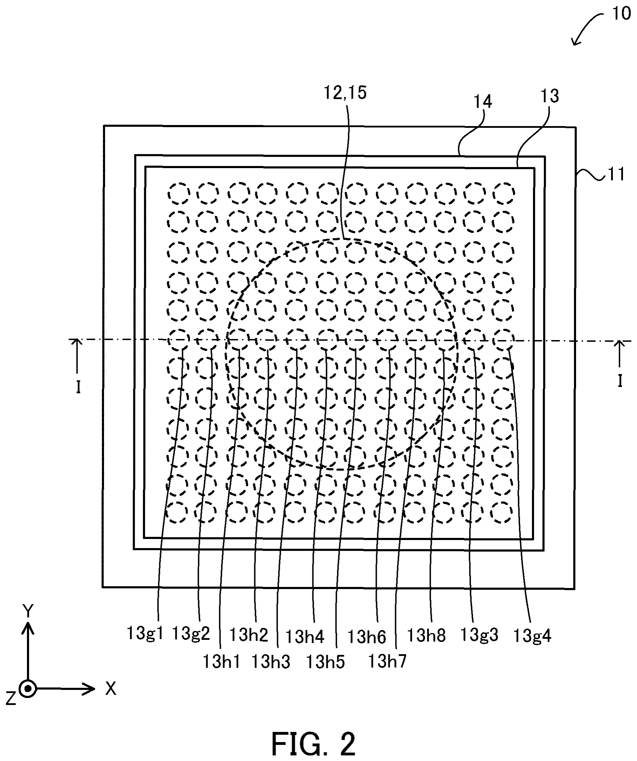

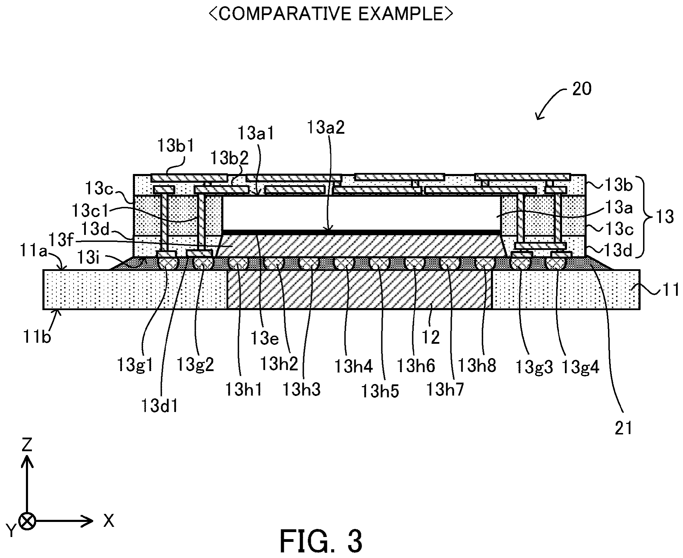

FIG. 1 is a cross-sectional view of an example of a semiconductor device according to a first embodiment. FIG. 2 is a top view of an example of the semiconductor device according to the first embodiment. Note that FIG. 1 is a cross-sectional view taken along a line I-I in FIG. 2. In FIG. 2, some elements below an upper surface of a semiconductor package 13 are indicated by broken lines. FIG. 3 is a cross-sectional view of a semiconductor device that is a comparative example. In FIG. 3, the elements that are the same as those in FIGS. 1 and 2 have been assigned the same reference numerals.

The semiconductor device 10 includes a printed circuit board 11, a metal plate 12, the semiconductor package 13 that is mounted on the printed circuit board 11, a first filling material 14, and a second filling material 15.

Printed wiring and pads (not illustrated) are formed on a surface 11a, which is an upper surface of the printed circuit board 11. Note that the printed circuit board 11 may be referred to as a "PCB".

The metal plate 12 is embedded in the printed circuit board 11. As depicted in FIG. 2, the metal plate 12 is formed in a circular shape in plan view. The shape of the metal plate 12 in plan view is not limited to a circle. However, by forming the plate into a circular shape, it is possible to absorb the difference in thermal expansion coefficient between the printed circuit board 11 and the metal plate 12, which prevents the metal plate 12 from falling off the printed circuit board 11. The metal plate 12 is preferably formed of a metal with high thermal conductivity. As examples, the metal plate 12 is formed of a metal such as copper (Cu) or aluminum (Al).

Heat generated at a semiconductor chip 13a in the semiconductor package 13 is transferred to the metal plate 12 via elements which will be described later. The metal plate 12 radiates this heat to below the metal plate 12. To reduce the thermal resistance between the semiconductor chip 13a and the metal plate 12, the metal plate 12 overlaps at least a part of the semiconductor chip 13a in plan view (as one example, a part where heat generation is concentrated due to the provision of an amplifier circuit or the like).

To dissipate heat efficiently, as depicted in FIG. 1, the metal plate 12 is preferably exposed on a surface 11a of the printed circuit board 11 and on a surface 11b which is a lower surface of the printed circuit board 11 and is opposite the surface 11a. However, the present disclosure is not limited to this configuration. For example, a part of the upper surface or the lower surface of the metal plate 12 may be exposed on the surface 11a or the surface 11b of the printed circuit board 11. The number of metal plates 12 is not limited to one, and a plurality of metal plates may be embedded in the printed circuit board 11.

The semiconductor package 13 includes a semiconductor chip 13a, rewiring layers 13b and 13d, a mold layer 13c, a barrier layer 13e, and a heat spreader layer 13f. The semiconductor package 13 further includes first connection terminals (for example, connection terminals 13g1 to 13g4 in FIGS. 1 to 3) and second connection terminals (for example, connection terminals 13h1 to 13h8 in FIGS. 1 to 3).

In the example of FIGS. 1 to 3, the semiconductor package 13 is a BGA package. A BGA package enables connection terminals, which are solder balls, to be arranged with a high density, thereby increasing the number of terminals in a small area.

The semiconductor chip 13a is an integrated circuit (IC) fabricated by a semiconductor manufacturing process. When the semiconductor package 13 is an AiP, the semiconductor chip 13a is a radio frequency (RF) chip including a heat generating unit such as an amplifier circuit. Terminals (not illustrated) are provided on an upper surface 13a1 of the semiconductor chip 13a.

The rewiring layer 13b is provided above the semiconductor chip 13a. The rewiring layer 13b is larger in size than the semiconductor chip 13a in plan view. The rewiring layer 13b may be configured by alternately stacking wiring layers and insulating layers, with the plurality of wiring layers being connected by vias. In the example in FIG. 1, the rewiring layer 13b includes wiring 13b2 electrically connected to a terminal (not illustrated) provided on the upper surface 13a1 of the semiconductor chip 13a. When the semiconductor package 13 is an AiP, uppermost wiring 13b1 in the rewiring layer 13b may be a patch antenna.

The mold layer 13c is provided so as to cover side surfaces of the semiconductor chip 13a. As one example, the mold layer 13c is produced using a mold material obtained by mixing a filler, such as alumina, into an epoxy resin or a resin-based material such as polyimide film. The mold layer 13c is provided with vias (for example, a via 13c1) that electrically connects wiring included in the rewiring layer 13b (as one example, wiring 13b2) and wiring included in the rewiring layer 13d (as one example, wiring 13d1).

The rewiring layer 13d is provided on a lower surface of the mold layer 13c. The rewiring layer 13d includes wiring (for example, wiring 13d1) electrically connected through a via in the mold layer 13c to wiring (for example, the wiring 13b2) included in the rewiring layer 13b.

The barrier layer 13e is provided on a lower surface 13a2 of the semiconductor chip 13a. As one example, a titanium (Ti) film or the like formed to a thickness of 0.02 to 0.2 µm by sputtering is used as the barrier layer 13e.

The heat spreader layer 13f is formed with its upper surface in contact with a lower surface of the barrier layer 13e and its lower surface exposed from a surface 13i, which is the lower surface of the semiconductor package 13. Side surfaces of the heat spreader layer 13f are covered with the rewiring layer 13d. The heat spreader layer 13f is preferably formed of a metal with high thermal conductivity. Example metals with high thermal conductivity include aluminum and copper. It is possible to form the heat spreader layer 13f in the same step as the step of fabricating the rewiring layer 13d.

Note that the upper surface of the heat spreader layer 13f may make direct contact with the lower surface 13a2 of the semiconductor chip 13a without the barrier layer 13e being provided.

In the example in FIGS. 1 to 3, the first connection terminals and the second connection terminals are all included in a connection terminal group of a BGA.

As depicted in FIGS. 1 to 3, the first connection terminals (for example, the connection terminals 13g1 to 13g4) are not in contact with the metal plate 12. As one example, as depicted in FIG. 1, the first connection terminals are provided on the surface 13i of the semiconductor package 13 and electrically connect the semiconductor chip 13a and the printed circuit board 11. As one example, the connection terminal 13g2 is electrically connected to a terminal (not illustrated) of the semiconductor chip 13a via the wiring 13d1 of the rewiring layer 13d, the via 13c1 in the mold layer 13c, and the wiring 13b2 of the rewiring layer 13b.

As depicted in FIGS. 1 to 3, the second connection terminals (for example, the connection terminals 13h1 to 13h8) are in contact with the metal plate 12 but are insulated from the semiconductor chip 13a. That is, the second connection terminals are not electrically connected to the terminals of the semiconductor chip 13a.

Out of the gap between the surface 11a of the printed circuit board 11 and the surface 13i of the semiconductor package 13, the first filling material 14 fills in a region that covers the first connection terminals. This region that covers the first connection terminals may also be said to be a region which, in plan view, is located outside the region filled with the second filling material 15, as depicted in FIG. 2. When the size of the region filled with the second filling material 15 is smaller than the size of the metal plate 12 in plan view, the first filling material 14 may slightly extend into part (as one example, an outer edge portion) of the metal plate 12.

Although a typical underfill material, such as an epoxy resin with a thermal conductivity of around 0.5 W/m·K, may be used as an example of the first filling material 14, it is also possible to use an underfill material with high thermal conductivity. As one example, an underfill material obtained by mixing a large amount of silica filler or alumina filler into epoxy resin may be used. Such underfill material has a thermal conductivity of around 1.5 to 2.0 W/m·K.

Out of the gap between the surface 11a of the printed circuit board 11 and the surface 13i of the semiconductor package 13, the second filling material 15 may fill at least a part of a region where the semiconductor chip 13a and the metal plate 12 overlap in plan view. The second filling material 15 has higher thermal conductivity than the first filling material 14.

As examples of the second filling material 15, a conductive material such as silver paste or copper paste may be used. The thermal conductivity of the silver paste is around 30 to 50 W/m·K, and the thermal conductivity of the copper paste is around 80 to 180 W/m·K. When an epoxy resin or an underfill material obtained by mixing a silica filler into an epoxy resin is used as the first filling material 14, an underfill material obtained by mixing alumina filler, which has a higher thermal conductivity than either, may be used as the second filling material 15.

To further reduce the thermal resistance between the semiconductor chip 13a and the metal plate 12, the second filling material 15 preferably fills the entire region that overlaps the metal plate 12 in plan view like in the example in FIG. 2.

As depicted in FIG. 3, in a semiconductor device 20 that is a comparative example, to ensure the strength and reliability of bonding, the entire gap between the surface 11a and the surface 13i is filled with a filling material 21. As the filling material 21, a material that is highly electrically insulating is used to achieve electrical insulation between the first connection terminals and between the first connection terminals and the second connection terminals. This makes it difficult to use a material with sufficiently high thermal conductivity, resulting in the heat dissipation efficiency of the semiconductor device 20 being insufficiently high.

As described above, the semiconductor device 10 according to the first embodiment includes the printed circuit board 11, the metal plate 12 embedded in the printed circuit board 11, the semiconductor package 13, the first filling material 14, and the second filling material 15. The semiconductor package 13 includes the semiconductor chip 13a, and is provided with the first connection terminals, which electrically connect the semiconductor chip 13a and the printed circuit board 11, on the surface 13i that faces the surface 11a of the printed circuit board 11. The first filling material 14 fills a region that covers the first connection terminals, out of the gap between the surface 11a and the surface 13i. The second filling material 15 fills in at least a part of a region of the gap where the semiconductor chip 13a and the metal plate 12 overlap each other in plan view. The second filling material 15 has higher thermal conductivity than the first filling material 14.

With this configuration, heat generated at the semiconductor chip 13a is transferred via the second filling material 15 to the metal plate 12 embedded in the printed circuit board 11. This reduces the thermal resistance between the semiconductor chip 13a and the metal plate 12, so that the heat generated by the semiconductor chip 13a is efficiently dissipated.

Note that out of the gap between the surface 11a and the surface 13i, the region covering the first connection terminals is filled with the first filling material 14, which maintains the overall bonding strength between the printed circuit board 11 and the semiconductor package 13.

In the semiconductor device 10, the second connection terminals (for example, the connection terminals 13h1 to 13h8) that contact the metal plate 12 but are insulated from the semiconductor chip 13a are provided on the surface 13i of the semiconductor package 13.

By doing so, it is possible to increase the bonding strength between the printed circuit board 11 and the semiconductor package 13. When a material with higher thermal conductivity than the second filling material 15 is used as the second connection terminals, the thermal resistance between the semiconductor chip 13a and the metal plate 12 is further reduced.

The second filling material 15 relates to the thermal connection between the semiconductor chip 13a and the printed circuit board 11 and is not related to electrical connections. This means that it is possible to use an electrically conductive material like those described earlier as the second filling material 15. By doing so, the thermal resistance between the semiconductor chip 13a and the metal plate 12 is further reduced.

The semiconductor device 10 may include a heat sink as described below.

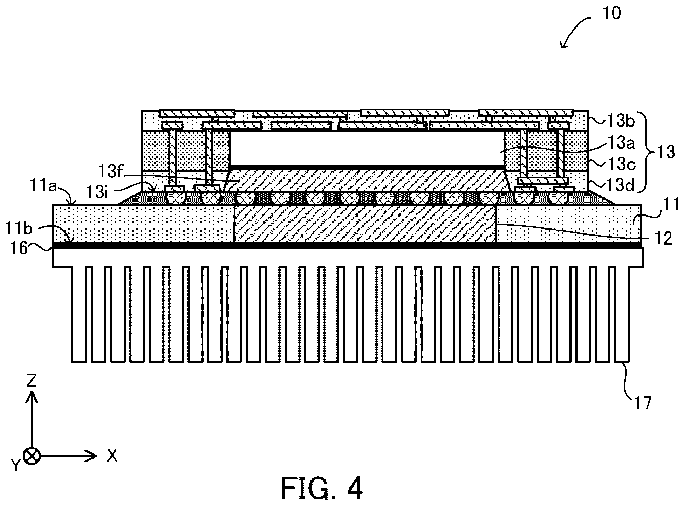

FIG. 4 depicts a mounted example of a heat sink.

In the example in FIG. 4, a heat sink 17 is attached to the surface 11b, which is the lower surface of the printed circuit board 11, via a thermal interface material (TIM) 16. The TIM 16 is provided to fill any gaps that may be generated between the printed circuit board 11 or metal plate 12 and the heat sink 17, thereby reducing the contact thermal resistance. As one example, thermal grease or the like is used as the TIM 16. Note that it is also possible to not provide the TIM 16 and place the heat sink 17 in direct contact with the surface 11b with no gap.

The heat sink 17 dissipates heat, which was generated at the semiconductor chip 13a and transferred via the second filling material 15 (and the second connection terminals) to the metal plate 12, to outside the semiconductor device 10. The heat sink 17 is made of steel, aluminum, or a material that combines the same.

In the semiconductor device 10, since the metal plate 12 is exposed on the surface 11b, which is the lower surface of the printed circuit board 11, it is possible to further increase the efficiency of heat dissipation by providing the heat sink 17 as described above.

### (Modifications)

Although the semiconductor device 10 depicted in FIGS. 1 and 2 includes the second connection terminals (for example, the connection terminals 13h1 to 13h8), the second connection terminals may be omitted.

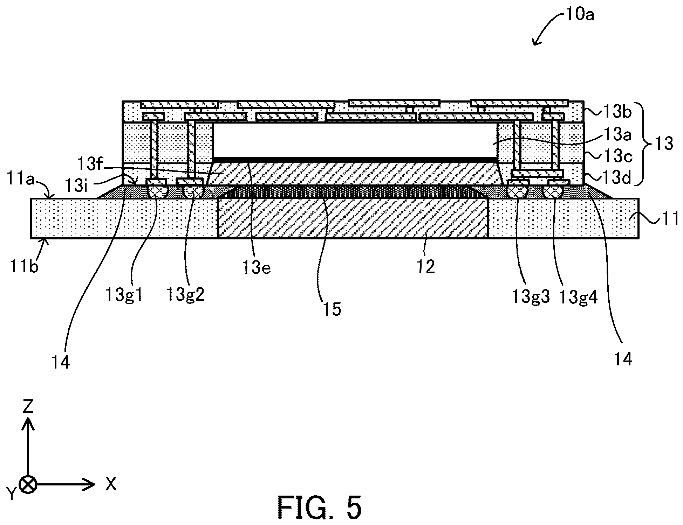

FIG. 5 depicts a modification of the semiconductor device according to the first embodiment. In FIG. 5, elements that are the same as those depicted in FIG. 1 have been assigned the same reference numerals.

Unlike the semiconductor device 10, a semiconductor device 10a depicted in FIG. 5 does not include the second connection terminals. Since this semiconductor device 10a is also provided with the second filling material 15, the thermal resistance between the semiconductor chip 13a and the metal plate 12 is reduced and heat generated by the semiconductor chip 13a is efficiently dissipated, thereby achieving the same effect as the semiconductor device 10.

As one example, the semiconductor devices 10 and 10a described above are applicable to a wireless communication device for mounting on a front-end wireless unit of a base station. In this case, the printed circuit board 11 is the motherboard of a base station for example, and the semiconductor package 13 is an AiP for example. When the semiconductor package 13 is an AiP, a high-frequency signal is amplified by the semiconductor chip 13a, and radio waves are emitted to the air via patch antennas disposed in an array provided in the uppermost layer of the rewiring layer 13b, for example.

Applications from recent 5G onward have made increasing use of millimeter waveband frequencies to support ultrahigh-speed communication, ultralow latency, and multiple simultaneous connections. In this situation, it is preferable for a mechanism for emitting radio waves into space via patch antennas disposed in an array to be provided in an adjacent region to reduce signal attenuation. In the case of an AiP, a patch antenna of a small area corresponding to a short wavelength is disposed. This creates a need to downsize the entire device including the AiP. For a device where downsizing is needed, since the AiP includes a high-power amplifier circuit, it is desirable to further increase the efficiency of heat dissipation.

To improve the efficiency of heat dissipation, it is desirable to use the lower surface side of the semiconductor chip 13a as a heat dissipation path as depicted in FIGS. 1, 3, and 5. This is because when a heat dissipation path is provided on the upper surface side of the semiconductor chip 13a and heat is dissipated to the printed circuit board 11 side through a heat dissipation path, vias that pass through the mold layer, or the like, the heat dissipation path will become narrow and elongated, which increases thermal resistance. However, in the semiconductor device 20 of the comparative example depicted in FIG. 3, since the thermal conductivity of the filling material 21 is low, the efficiency of heat dissipation is not sufficiently high, which may prevent further reductions in the size of the device or fail to cope with situations where the heat generation of the semiconductor chip 13a increases.

In addition to the first filling material 14 that fills the region covering the first connection terminals, the semiconductor devices 10 and 10a further include the second filling material 15 that fills at least a part of the region where the semiconductor chip 13a and the metal plate 12 overlap each other in plan view. The second filling material 15 has higher thermal conductivity than the first filling material 14 and may use a material that is electrically conductive. This means that the semiconductor devices 10 and 10a dissipate heat more efficiently than the semiconductor device 20 of the comparative example. Accordingly, the semiconductor devices 10 and 10a are suitable for a wireless communication device including an AiP where high heat dissipation efficiency is needed.

However, the semiconductor package 13 is not limited to the structure described above that is suitable for an AiP. The semiconductor package 13 is also not limited to a BGA package. As one example, so long as the position of the metal plate 12 and the positions of the first connection terminals do not overlap each other in plan view, a wafer level chip size package (CSP), a flip chip package in which the terminal surface of the semiconductor chip 13a is on the bottom, or the like may also be used.

### (Second Embodiment)

As described earlier, the second filling material 15 has higher thermal conductivity than the first filling material 14. Many materials with high thermal conductivity also have high electrical conductivity. When a second filling material 15 with high electrical conductivity contacts a first connection terminal that electrically connects the printed circuit board 11 and the semiconductor chip 13a, the reliability of the device as a whole will decrease. The semiconductor device according to the second embodiment described below has a structure that prevents this situation from occurring.

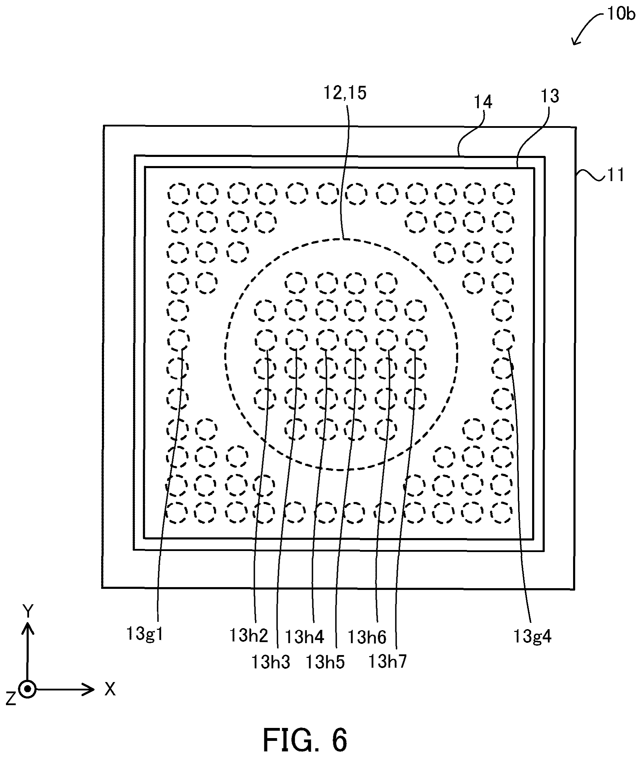

FIG. 6 is a top view of one example of a semiconductor device according to the second embodiment. In FIG. 6, elements that are the same as those depicted in FIG. 2 have been assigned the same reference numerals.

In the semiconductor device 10b according to the second embodiment, the density with which the first connection terminals or the second connection terminals are arranged in a boundary part between the printed circuit board 11 and the metal plate 12 in plan view is lower than the density with which the first connection terminals or the second connection terminals are arranged in regions aside from the boundary part.

In the example of the semiconductor device 10b in FIG. 6, the connection terminals 13g2, 13g3, 13h1, 13h8, and the like, which were provided in the vicinity of the boundary between the printed circuit board 11 and the metal plate 12 in FIG. 2, are not provided.

The first filling material 14 and the second filling material 15 are more likely to spread in a region where the density of the first connection terminals and the second connection terminals is high than in a region where the density of the first connection terminals and the second connection terminals is low. This is because it is easy the first filling material 14 and the second filling material 15 to fill a region where the density of the first connection terminals and the second connection terminals is high due to the wettability of the surfaces of the first connection terminals and the second connection terminals.

In the semiconductor device 10b depicted in FIG. 6, since the density of the first connection terminals or the second connection terminals is low at the boundary part between the printed circuit board 11 and the metal plate 12, the first filling material 14 and the second filling material 15 are less likely to spread. This prevents the second filling material 15 from flowing into the region where the first connection terminals are disposed and coming into contact with a first connection terminal. This improves the reliability of the device as a whole, including the semiconductor device 10b. In addition, it is possible to prevent the first filling material 14 with low thermal conductivity from flowing onto the metal plate 12 and causing deterioration in heat dissipation performance.

### (Third Embodiment)

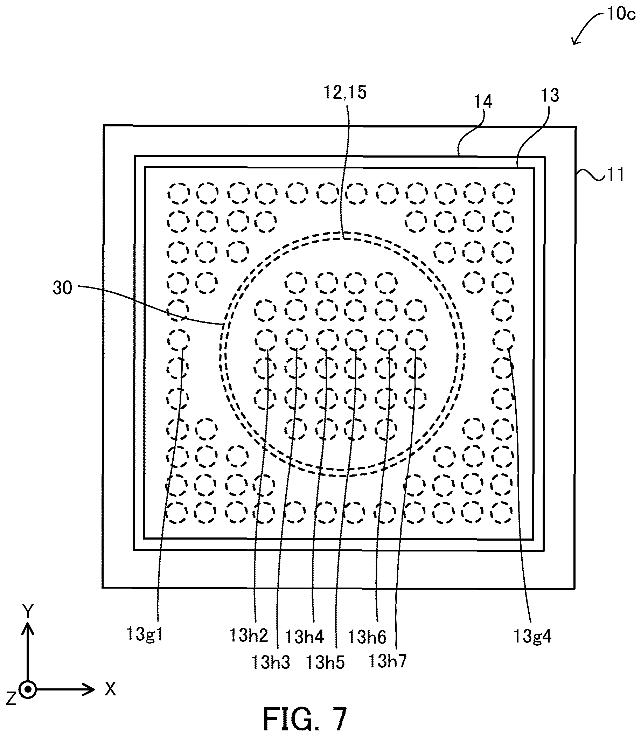

FIG. 7 is a top view of one example of the semiconductor device according to the third embodiment. In FIG. 7, elements that are the same as those depicted in FIG. 3 have been assigned the same reference numerals.

In a semiconductor device 10c according to the third embodiment, gold (Au) film 30 is provided along the boundary between the printed circuit board 11 and the metal plate 12 in plan view. Note that the gold film 30 may be formed so as to cross the boundary between the printed circuit board 11 and the metal plate 12, may be formed on the metal plate 12 inside the boundary, or may be formed on the printed circuit board 11 outside the boundary. The gold film 30 may be formed at positions along the boundary between the printed circuit board 11 and the metal plate 12 in plan view on the surface 13i of the semiconductor package 13 depicted in FIG. 1 and the like. The gold film 30 may be formed on both the printed circuit board 11 (or the metal plate 12) and the semiconductor package 13.

One property of gold is low wettability for liquid materials such as an underfill material, silver paste, and copper paste (that is, gold constantly repels such liquid materials). This means that by providing the gold film 30, it is possible to prevent the second filling material 15 from flowing into the region where the first connection terminals are disposed and coming into contact with a first connection terminal. It is also possible to prevent the first filling material 14 that has low thermal conductivity from flowing onto the metal plate 12 and causing deterioration in heat dissipation performance.

It is possible to form the gold film 30 by electroless plating, sputtering, or the like. To prevent the first filling material 14 and the second filling material 15 from passing over the gold film 30, the gold film 30 preferably has a width of around 100 µm or more and a height of around 50 µm or more, for example.

In the semiconductor device 10c, in the same way as the semiconductor device 10b according to the second embodiment, the density of the first connection terminals or the second connection terminals in the boundary part between the printed circuit board 11 and the metal plate 12 in plan view is lower than the density of the first connection terminals or the second connection terminals in the regions aside from the boundary part. However, it is also possible to provide the gold film 30 as described above in the semiconductor device 10 according to the first embodiment.

### (Mounting Method)

Next, an example of a mounting method will be described. Hereinafter, a method of mounting the semiconductor device 10 according to the first embodiment will be described as an example.

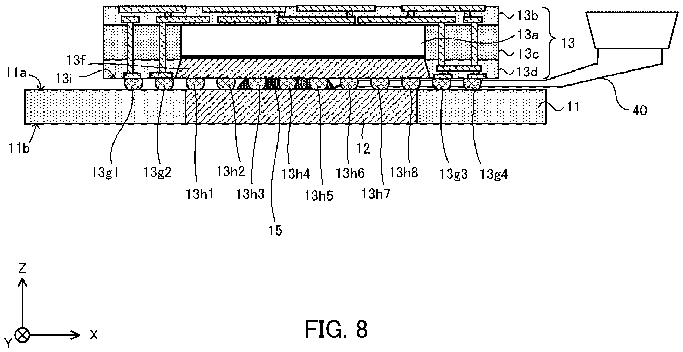

FIG. 8 depicts a first step in the mounting method. In FIG. 8, elements that are the same as those depicted in FIG. 1 have been assigned the same reference numerals.

As depicted in FIG. 8, the semiconductor package 13 is disposed at an appropriate position on the printed circuit board 11 in which the metal plate 12 is embedded. As one example, the semiconductor package 13 is positioned so that the first connection terminals (the connection terminals 13g1 to 13g4 and the like) are positioned so as to come into contact with pads (not illustrated) on the surface 11a of the printed circuit board 11 and the second connection terminals (the connection terminals 13h1 to 13h8 and the like) come into contact with the metal plate 12. The printed circuit board 11 and the semiconductor package 13 are then soldered together by heating.

After this, out of the gap between the surface 11a and the surface 13i, at least a part of the region where the semiconductor chip 13a and the metal plate 12 overlap in plan view is filled with the second filling material 15. An appropriate amount of the second filling material 15 is injected at or near the center of the region using a tubular jig 40 for example. When doing so, the injected amount is adjusted so that the second filling material 15 does not flow out onto the printed circuit board 11.

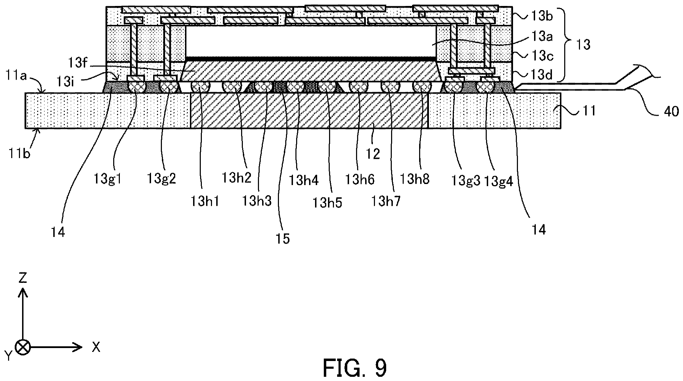

FIG. 9 depicts a second step in the mounting method. In FIG. 9, elements that are the same as those depicted in FIG. 1 have been assigned the same reference numerals.

After filling with the second filling material 15, out of the gap between the surface 11a and the surface 13i, a region that covers the first connection terminals is filled with the first filling material 14. An appropriate amount of the first filling material 14 is injected at or near the outer edge of the region that covers the first connection terminal using the tubular jig 40, for example. When doing so, the injected amount is adjusted so that the first filling material 14 does not flow out onto the metal plate 12.

After this, the first filling material 14 and the second filling material 15 in liquid form are hardened and fixed by a high-temperature firing process. Through steps like those described above, the semiconductor device 10 is manufactured.

Note that it is also possible to manufacture the semiconductor device 10 by performing the following steps.

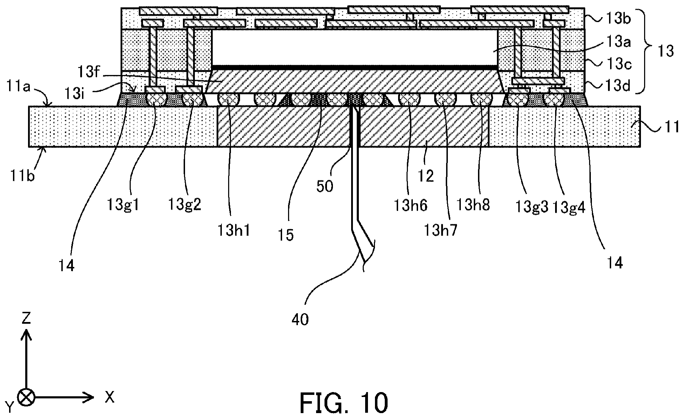

FIG. 10 depicts a process in another mounting method. In FIG. 10, elements that are the same as those depicted in FIG. 1 have been assigned the same reference numerals.

As depicted in FIG. 10, the metal plate 12 is provided with a through hole 50 into which the tubular jig 40 is inserted. As one example, the through hole 50 is provided at or near the center of the metal plate 12 in plan view. An appropriate amount of the second filling material 15 is injected through the through hole 50 into at or near the center of the metal plate 12.

The first filling material 14 is injected as depicted in FIG. 9, and in the mounting method depicted in FIG. 10, the first filling material 14 may be injected before or after injection of the second filling material 15. That is, in the present mounting method, there is no restriction on the injection order of the first filling material 14 and the second filling material 15. When the diameter of the through hole 50 is larger than the distance between the surface 11a and the surface 13i, it is possible to use even a relatively thick tubular jig 40 which would be difficult to insert into the gap between the surface 11a and the surface 13i.

Although an example of a method of mounting the semiconductor device 10 has been described above, it is also possible to manufacture the semiconductor device 10a of the modification illustrated in FIG. 5 and the semiconductor device 10b according to the second embodiment using the same method with only the arrangement of the first connection terminals or the second connection terminals differing. It is also possible to manufacture the semiconductor device 10c according to the third embodiment depicted in FIG. 7 with the same method as described above, except for the addition of a step of forming the gold film 30 along the boundary between the printed circuit board 11 and the metal plate 12 in plan view.

Although aspects of a semiconductor device and a mounting method thereof according to the present disclosure have been described above based on several embodiments, such embodiments are mere examples and the present disclosure is not limited to the above description.

### Reference Signs List

- 10: Semiconductor device
- 11: Printed circuit board
- 11a, 11b, 13i: Surface
- 12: Metal plate
- 13: Semiconductor package
- 13a: Semiconductor chip
- 13a1: Upper surface
- 13a2: Lower surface
- 13b,: 13d Rewiring layer
- 13b1, 13b2, 13d1: Wiring
- 13c: Mold layer
- 13c1: Via
- 13e: Barrier layer
- 13f: Heat spreader layer
- 13g1 to 13g4, 13h1 to 13h8: Connection terminals
- 14: First filling material
- 15: Second filling material

## Claims

1. A semiconductor device comprising:
a printed circuit board;
a metal plate embedded in the printed circuit board;
a semiconductor package that includes a semiconductor chip and is provided with first connection terminals for electrically connecting the semiconductor chip and the printed circuit board on a second surface that faces a first surface of the printed circuit board;
a first filling material that fills a first region, which covers the first connection terminals, out of a gap between the first surface and the second surface; and
a second filling material that has higher thermal conductivity than the first filling material and fills at least a part of a second region, where the semiconductor chip and the metal plate overlap in a plan view, of the gap.

2. The semiconductor device according to claim 1,
wherein the semiconductor package includes second connection terminals on the second surface, the second connection terminals being in contact with the metal plate and insulated from the semiconductor chip.

3. The semiconductor device according to claim 2,
wherein in the plan view, a density with which the first connection terminals or the second connection terminals are disposed in a boundary part between the printed circuit board and the metal plate is lower than a density with which the first connection terminals or the second connection terminals are disposed in regions aside from the boundary part.

4. The semiconductor device according to claim 2,
wherein the first connection terminals and the second connection terminals are included in a connection terminal group of a ball grid array.

5. The semiconductor device according to claim 1,
wherein a gold film is provided along a boundary between the printed circuit board and the metal plate in the plan view.

6. The semiconductor device according to claim 1,
wherein the second filling material is an electrically conductive material.

7. The semiconductor device according to claim 1,
wherein the metal plate is exposed on the first surface and a third surface of the printed circuit board that is opposite the first surface.

8. A mounting method comprising:
disposing a semiconductor package, which includes a semiconductor chip and is provided with first connection terminals for electrically connecting the semiconductor chip to a printed circuit board on a second surface that faces a first surface of the printed circuit board, on the printed circuit board in which a metal plate is embedded;
filling a first region, which covers the first connection terminals, out of a gap between the first surface and the second surface with a first filling material; and
filling at least a part of a second region of the gap, where the semiconductor chip and the metal plate overlap in a plan view, with a second filling material with higher thermal conductivity than the first filling material.

9. The mounting method according to claim 8,
wherein the metal plate includes a through hole, and the at least part of the second region is filled with the second filling material via the through hole.

10. The mounting method according to claim 8,
wherein the semiconductor package includes second connection terminals on the second surface, the second connection terminals being in contact with the metal plate and insulated from the semiconductor chip.

11. The mounting method according to claim 10,
wherein in the plan view, a density with which the first connection terminals or the second connection terminals are disposed in a boundary part between the printed circuit board and the metal plate is lower than a density with which the first connection terminals or the second connection terminals are disposed in regions aside from the boundary part.

12. The mounting method according to claim 10,
wherein the first connection terminals and the second connection terminals are included in a connection terminal group of a ball grid array.

13. The mounting method according to claim 8,
wherein gold film is provided along a boundary between the printed circuit board and the metal plate in the plan view.

14. The mounting method according to claim 8,
wherein the second filling material is an electrically conductive material.

15. The mounting method according to claim 8,
wherein the metal plate is exposed on the first surface and a third surface of the printed circuit board that is opposite the first surface.
